# EUROPEAN PATENT SPECIFICATION

(11) **EP 4 088 251 B1**
(45) Date of publication and mention of the grant of the patent: **14.05.2025**
(21) Application number: 21738986.5
(22) Date of filing: 07.01.2021
(51) Int. Cl.: G01C 15/00, G06F 30/18, G06Q 10/10, G06T 7/521, G06T 7/55, G06T 17/05, G01C 11/04, G06F 30/13, G06Q 50/08

(54) **BUILDING INFORMATION MODELING (BIM) DATA MODEL FOR CONSTRUCTION INFRASTRUCTURE**
DATENMODELL ZUR GEBÄUDEINFORMATIONSMODELLIERUNG (BIM) FÜR GEBÄUDEINFRASTRUKTUR
MODÈLE DE DONNÉES DE MODÉLISATION D'INFORMATIONS DE CONSTRUCTION (BIM) D'INFRASTRUCTURE DE CONSTRUCTION

(30) Priority: 07.01.2020 US 202062957897 P
(43) Date of publication of application: 16.11.2022
(73) Proprietor: Datumate Ltd., 2066727 Yoqneam llit (IL)
(72) Inventor: JARROUSH, Jad, 17500 Nazareth Illit (IL)
(74) Representative: Forresters IP LLP
(86) International application number: PCT/IL2021/050024
(87) International publication number: WO 2021/140514

(56) References cited:
- US-A1- 2013 173 632
- US-A1- 2015 278 402
- US-A1- 2017 132 568
- US-A1- 2018 349 522
- US-A1- 2019 205 310
- US-A1- 2019 285 412
- US-A1- 2019 325 089
- LEE NAMHUN ET AL: "Building Information Modeling for Quality Management in Infrastructure Construction Projects", COMPUTING IN CIVIL AND BUILDING ENGINEERING (2014), 17 June 2014 (2014-06-17), Reston, VA, pages 65 - 72, XP055841206, ISBN: 978-0-7844-1361-6, Retrieved from the Internet <URL:https://itc.scix.net/pdfs/w78-2014-paper-009.pdf> DOI: 10.1061/9780784413616.009
- LEE NAMHUN, SALAMA TALAT, WANG GEORGE: "Building Information Modeling for Quality Management in Infrastructure Construction Projects", ASCE, 17 June 2014 (2014-06-17), pages 65 - 72, XP055841206

## Description

### REFERENCE TO RELATED PATENT PUBLICATIONS

Reference is hereby made to U.S. Provisional Patent Application No. 62/957,897, entitled 'BUILDING INFORMATION MODELING (BIM) DATA MODEL FOR CONSTRUCTION INFRASTRUCTURE, filed January 7, 2020.

Reference is also made to the following patent publications of assignee:
U.S. Patent No. 8,458,140; and
U.S. Patent Publication Nos. 2017/0059317 and 2019/0285412.

### FIELD OF THE INVENTION

The present invention relates to construction engineering generally and more particularly to implementation of construction projects.

### BACKGROUND OF THE INVENTION

Various types of computer-aided engineering technologies are known in the prior art. US 2018/349522 A1 discloses an adaptive modelling of building during construction. US 2019/325089 A1 discloses a computation of point clouds and joint display of point clouds and building information models with project schedules for monitoring construction progress, productivity, and risk for delays. Lee Namhun et al., "Building Information Modeling for Quality Management in Infrastructure Construction Projects", COMPUTING IN CIVIL AND BUILDING ENGINEERING (2014), Reston, VA, pages 65 - 72, places focus on the utilization of BIM for quality management in highway and bridge construction.

### SUMMARY OF THE INVENTION

The present invention seeks to provide improved methods and systems for construction engineering, particularly for large scale infrastructure projects such as roads.

There is thus provided in accordance with a preferred embodiment of the present invention a method for dynamic modeling of infrastructure projects over time, the method including receiving an infrastructure project design comprising: at least one of a three-dimensional view of an infrastructure project to be built and a set of two-dimensional views of the infrastructure project; and material layer defining information relating to the infrastructure project, defining a plurality of design volume-surface-objects (DVSOs), each corresponding to a material layer of the infrastructure project, ascertaining at least a volume of each of the DVSOs, repeatedly imaging the infrastructure project over time during construction thereof to produce multiple images acquired at a plurality of different times, automatically generating a point cloud representing the infrastructure project at each of the plurality of different times, based on the images, the point cloud including multiple points each having known Cartesian coordinates, automatically generating a surface mapping representing the infrastructure project at each of the plurality of different times, based on the point clouds, automatically generating a plurality of as-built volume-surface-objects (ABVSOs), each based on a pair of the surface mappings, each of the ABVSOs corresponding to one of the plurality of DVSOs, and employing the ABVSOs and the DVSOs for constructing and managing the infrastructure project.

Preferably, the set of two-dimensional views includes at least one horizontal alignment view of the infrastructure project, at least one vertical alignment view of the infrastructure project, and a multiplicity of sectional views taken perpendicular to the at least one horizontal view.

Preferably, the employing the ABVSOs and the DVSOs for constructing and managing the infrastructure project includes at least one of providing control instructions to construction machinery used in constructing the infrastructure project, accounting and paying for at least one of excavating and moving earth for constructing the infrastructure project, accounting and paying for materials used in the infrastructure project, monitoring progress of the infrastructure project vis-à-vis a predetermined schedule and monitoring progress of the infrastructure project vis-à-vis a pre-defined design.

Preferably, the method also includes graphically representing the infrastructure project at each of the plurality of different times.

In accordance with a preferred embodiment of the present invention, the imaging includes at least one of photographing by a camera and laser scanning.

Additionally or alternatively, the method also includes employing RTK GPS positioning techniques to enhance a precision of the multiple points including the point cloud.

In accordance with another preferred embodiment of the present invention, defining a plurality of DVSOs includes automatically defining at least one DVSO and automatically defining within the a least one DVSO sub-DVSOs included in the at least one DVSO.

Preferably, the method also includes assigning at least one parameter to the at least one DVSO, the sub-DVSOs included in the at least one DVSO automatically inheriting the at least one parameter from the at least one DVSO.

Preferably, the assigning at least one parameter includes at least one of assignation of a sub-contractor contracted to construct the at least one DVSO, assignation of scheduled start date for construction of the at least one DVSO, assignation of a scheduled completion date for construction of the at least one DVSO, and assignation of an identification number of the at least one DVSO.

Preferably, the method also includes importing at least one modeled finite element to be located at a location within the infrastructure project, from an external Building Information Modelling (BIM) platform having modeled the finite element to the plurality of DVSOs, and incorporating the at least one finite element within ones of the plurality of DVSOs corresponding to the location.

There is also provided in accordance with another preferred embodiment of the present invention a system for dynamic modeling of infrastructure projects over time, the system including a project design generator operative to generate an infrastructure project design including at least one of a three-dimensional view of an infrastructure project to be built and a set of two-dimensional views of the infrastructure project and material layer defining information relating to the infrastructure project, a design volume-surface-objects (DVSOs) generator operative to define a plurality of DVSOs, each corresponding to a material layer of the infrastructure project, a DVSO geometrical property calculator operative to ascertain at least one geometrical property of each of the DVSOs, an image generator operative to repeatedly image the infrastructure project over time during construction thereof to produce multiple images acquired at a plurality of different times, a point cloud generator operative to automatically generate a point cloud representing the infrastructure project at each of the plurality of different times, based on the images, the point cloud including multiple points each having known Cartesian coordinates, a surface mapping generator operative to automatically generate a surface mapping representing the infrastructure project at each of the plurality of different times, based on the point clouds, an As-Built Volume-Surface Object generator operative to automatically generate a plurality of as-built volume-surface-objects (ABVSOs), each based on a pair of the surface mappings, each of the ABVSOs corresponding to one of the plurality of DVSOs and project construction and management functionality operative to employ the ABVSOs and the DVSOs for constructing and managing the infrastructure project.

Preferably, the set of two-dimensional views includes at least one horizontal alignment view of the infrastructure project, at least one vertical alignment view of the infrastructure project and a multiplicity of sectional views taken perpendicular to the at least one horizontal view.

Preferably, the project construction and management functionality is operative to at least one of provide control instructions to construction machinery used in constructing the infrastructure project, account and pay for at least one of excavating and moving earth for constructing the infrastructure project, account and pay for materials used in the infrastructure project, monitor progress of the infrastructure project vis-à-vis a predetermined schedule and monitor progress of the infrastructure project vis-à-vis a pre-defined design.

Preferably, the project construction and management functionality also includes project reporting functionality operative to graphically represent the infrastructure project at each of the plurality of different times.

In accordance with a preferred embodiment of the present invention, the image generator includes at least one of a camera and a laser scanner.

Additionally or alternatively, the image generator includes RTK GPS positioning equipment.

Preferably, the DVSO generator is operative to automatically define at least one DVSO and to automatically define within the a least one DVSO sub-DVSOs included in the at least one DVSO.

Preferably, the DVSO generator is operative to assign at least one parameter to the at least one DVSO, the sub-DVSOs included in the at least one DVSO automatically inheriting the at least one parameter from the at least one DVSO.

Preferably, the DVSO generator being operative to assign at least one parameter to the at least one DVSO includes at least one of assignation of a sub-contractor contracted to construct the at least one DVSO, assignation of scheduled start date for construction of the at least one DVSO, assignation of a scheduled completion date for construction of the at least one DVSO, and assignation of an identification number of the at least one DVSO.

Preferably, the system is further operative to import at least one modeled finite element to be located at a location within the infrastructure project, from an external Building Information Modelling (BIM) platform having modeled the finite element to the plurality of DVSOs, and to incorporate the at least one finite element within ones of the plurality of DVSOs corresponding to the location.

### BRIEF DESCRIPTION OF DRAWINGS

The present invention will be understood and appreciated from the following detailed description, taken in conjunction with the drawings in which:
Fig. 1 is a simplified functional block diagram of a construction management system constructed and operative in accordance with a preferred embodiment of the present invention;
Fig. 2 is a simplified horizontal alignment view of a portion of a road to be built;
Fig. 3 is a simplified vertical alignment view of a portion of a road to be built;
Fig. 4 is a simplified sectional view showing a portion of a road to be built;
Fig. 5 is a simplified isometric view showing a portion of a road to be built:
Fig. 6 is a simplified partially sectional illustration of material layers of a portion of a road to be built;
Fig. 7 is a simplified conceptual illustration of automatically generated Design Volume - Surface - Objects (DVSOs) in the context of a road to be built;
Fig. 8 is a simplified conceptual illustration of sub-DVSO's included in one of the DVSOs shown in Fig. 7, several of which DVSOs include a finite element automatically imported and incorporated from an external construction management system;
Fig. 9 is a simplified illustration of various surface mapping algorithms useful in the construction system of Fig. 1;
Fig. 10 is a simplified illustration of automatic mapping of an As-Built Volume-Surface-Object (ABVSO) to a DVSO, in accordance with a preferred embodiment of the present invention;
Figs. 11A and 11B combined form a simplified flowchart illustrating a construction method operative in accordance with a preferred embodiment of the present invention; and
Figs. 12A and 12B combined form a simplified flowchart illustrating the construction method of Figs. 11A and 11B applied to the construction of a stretch of a road.

### DETAILED DESCRIPTION OF PREFERRED EMBODIMENT

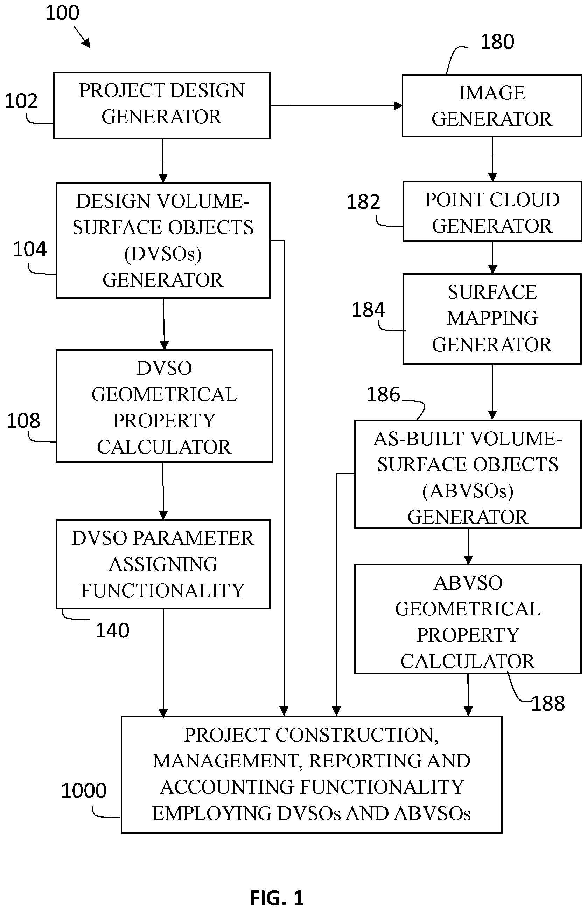

Reference is now made to Fig. 1, which is a simplified functional block diagram of a construction management system constructed and operative in accordance with a preferred embodiment of the present invention.

The construction management system of the present invention combines the use of design data, such as design data generated by conventional computerized design systems and software, and empirical data, such as data derived from aerial photographs, to define and employ design volume-surface-objects (DVSOs) and as-built volume-surface-objects (ABVSOs) generated at various times for implementation of construction projects, monitoring and reporting progress and accounting throughout the duration of construction projects and maintenance following completion of the construction project.

While it is appreciated that the system and method of the present invention may be employed in any suitable construction project, the system and method of the present invention are particularly suitable for use in large construction projects, such as road building. Accordingly, much of the description which follows relates to the use of the invention in the context of a road building project.

Referring to Fig. 1, it is seen that a construction management system 100 of the present invention may comprise a project design generator 102. Initially a project design, such as an infrastructure design, is generated by the project design generator 102. Examples of suitable project design generators 102 include workstations, such as a conventional PC or workstation running AutoCAD Civil 3D software, commercially available from Autodesk, Inc. of San Rafael, CA, USA.

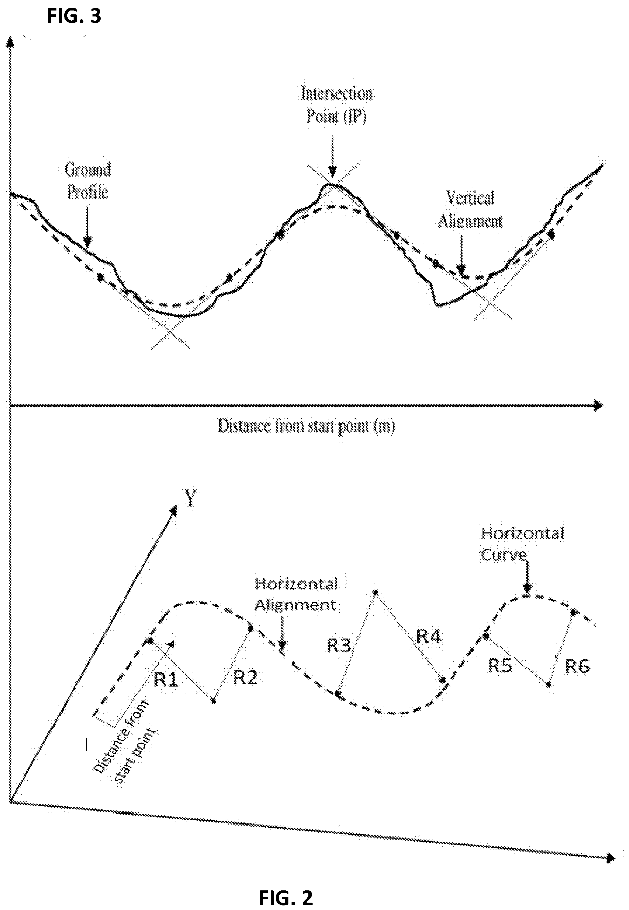

The project design produced by the project design generator 102 may include a set of two-dimensional views of the project. The set of two-dimensional views preferably includes at least one horizontal alignment view of the project. An example of a horizontal alignment view of a portion of a road project appears in Fig. 2. Fig. 2 references a start point, which is an arbitrary point along the road to be built, from which the view begins. In the example of Fig. 2, it is seen that the road curves initially to the right, and thereafter to the left and thereafter to the right.

Preferably, the set of two-dimensional views of the project produced by the project design generator 102 also includes at least one vertical alignment view of the project. An example of a vertical alignment view of a portion of a road project appears in Fig. 3. Fig. 3 preferably also references a start point, which is an arbitrary point along the road to be built, from which the view begins. In the example of Fig. 3, it is seen that the road dips initially and then rises and thereafter dips.

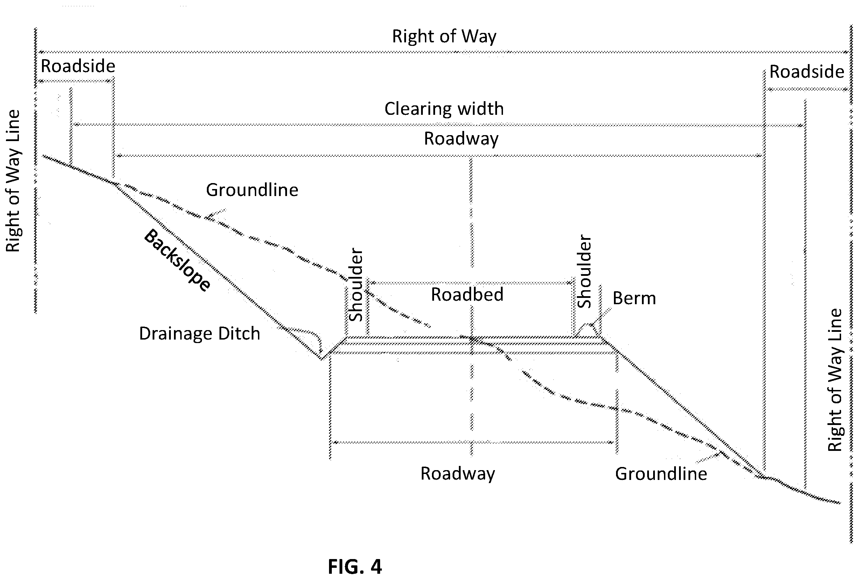

Additionally, the set of two-dimensional views of the project produced by the project design generator 102 also preferably includes a multiplicity of sectional views taken perpendicular to the progression of the horizontal view of Fig. 2. An example of such a sectional view in a road-building project appears in Fig. 4 and shows not only the cross-sectional topography at the outset of the project but also the cross-sectional configuration of the proposed finished road and its surrounding right of way. In road building design, preferably sectional views are generated at a multiplicity of locations spaced from each other by approximately 10 meters all along the length of the road to be built.

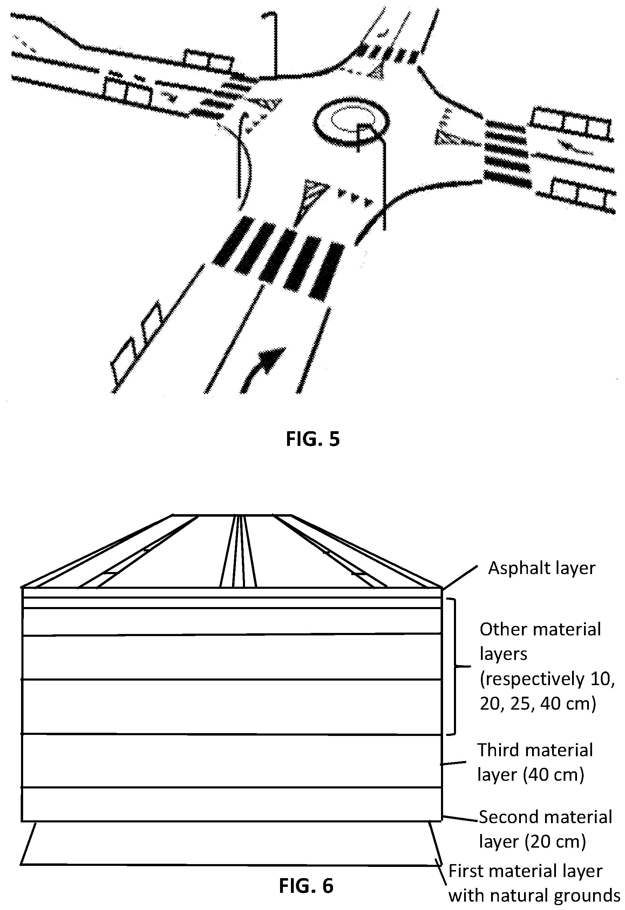

Additionally or alternatively, the project design generator 102 may produce a three-dimensional (3D) view of the project. An example of 3D view of a portion of a road project appears in Fig. 5.

Further, the project design produced by the project design generator 102 also preferably includes material layer defining information, indicating the structural elements incorporated in the project. Such information may be in the form of an image, such as that which appears in Fig. 6, and shows a cross-sectional configuration and thicknesses of the various material layers in a road to be built. The project design generator may include only one material layer defining view, such as that shown in Fig. 6, or more than one material layer defining view, depending on the specific material layer structure of the project. It is understood that in the case that project design generator produces a 3D design view, such a 3D design view may in some instances include material layer defining information, such that no additional material layer defining view is required.

Returning to Fig. 1, a Design Volume-Surface-Objects (DVSOs) Generator 104, receives the above-described data from the project design generator 102 and, preferably automatically, generates a plurality of Design-Volume-Surface Objects (DVSOs). DVSOs may be any suitable constructed object. In the context of road building, each separate material layer, such as each of the material layers shown in Fig. 6, may be a DVSO.

The material volume of the DVSO is preferably calculated by a DVSO Geometrical Property Calculator 108 and subsequently employed for project progress reporting and accounting, as is described in greater detail henceforth. It is understood that DVSO Geometrical Property Calculator 108 is not limited to calculating the volume of the DVSO, but may also calculate other geometrical properties of the DVSO, including, for example, surface area, surface length, slope, and any other relevant properties.

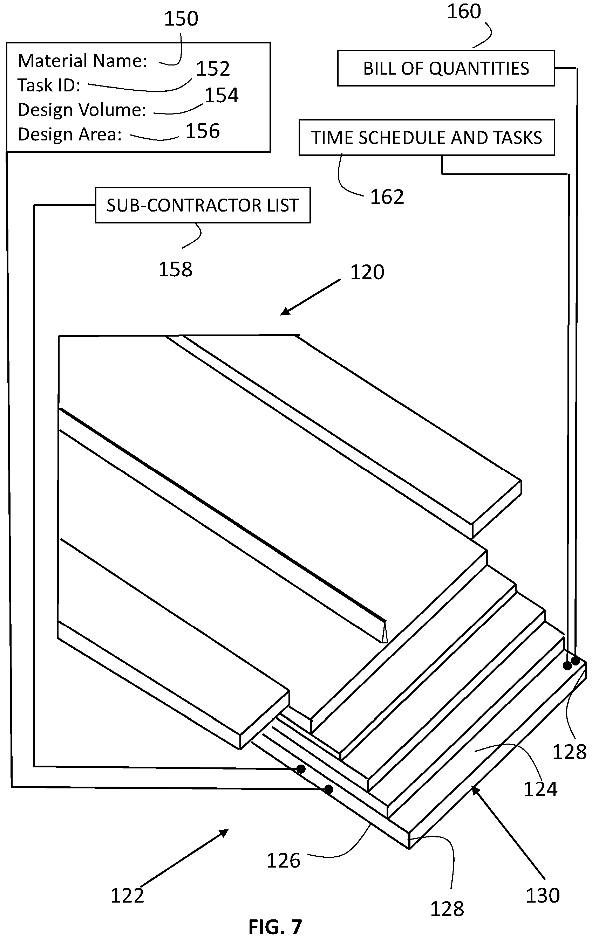

The generation of DVSOs by DVSO generator 104 may be better understood with additional reference to Fig. 7, which is a simplified conceptual illustration of automatically generated DVSOs in the context of a road to be built.

As seen in Fig. 7, a portion 120 of a road to be built may comprise multiple layers 122, which layers 122 are automatically derived from the data input to DVSO generator 104 from project design generator 102. Each of layers 122 may be defined by two surfaces, such as an upper surface 124 and a lower surface 126, illustrated with respect to one of layers 122. Upper and lower surfaces 124 and 126 may be linearly connected to one another at boundaries thereof by linear connecting lines 128. It is appreciated that upper and lower surfaces 124 and 126, connected at boundaries thereof by linear connecting lines 128, enclose and define a volumetric geometrical unit 130. Such a volumetric geometrical unit 130 may be automatically generated by DVSO generator 104 for each of layers 122 of road portion 120.

DVSO generator 104 is preferably operative to create a computerized volumetric virtual memory unit corresponding to and representing each volumetric geometrical unit 130. The volumetric geometrical unit 130 and the volumetric virtual memory unit by which the volumetric geometrical unit 130 may be represented are referred to interchangeably herein as a volume-surface-object (VSO). The volume of each VSO, as enclosed by the bounding lines and surfaces thereof (for example, 124, 126 and 128) may be automatically calculated by DVSO calculator 108.

It is appreciated that layers 122 and VSOs 130 defined based thereon are shown in an even, staggered highly simplified configuration in Fig. 7 for the purpose of simplicity and clarity of presentation thereof. In actuality, layers 122 may have mutually different sizes and shapes and be arranged in various fully or partially overlying configurations with respect to one another, depending on the design of the project to be built.

Returning to Fig. 1, DVSO parameter assigning functionality 140 preferably assigns parameters to the DVSOs generated by DVSO generator 104.

Each VSO preferably has the properties of a computerized data object and may contain a number of parameters, computational functions or links to other VSOs or databases. By way of example only, as shown in Fig. 7, a VSO such as VSO 130 may contain parameters such as the name of the material comprising the VSO 150, the task ID assigned to the VSO 152, the design volume of the VSO 154, the design area of the VSO 156, the name of the sub-contractor responsible for constructing the VSO 158, the bill of quantities associated with the VSO 160 and the time schedule and tasks associated with the VSO 162, such as the planned start and completion date of the VSO. Other relevant properties may be added, depending on the particular nature of the project to be constructed. These parameters are assigned by DVSO parameter assigning functionality 140 based on the relevant parameters being input to DVSO parameter assigning functionality 140 in the form of the various design data generated by project design generator 102, as well as from other external data sources, such as, by way of example only, MS Project files, Primavera and SKN.

The generation of VSOs thus allows automatic partition of the project to be built, such as a road, into discrete 3D units, which units enable and form the basis of BIM management of the project, as is described in further detail henceforth

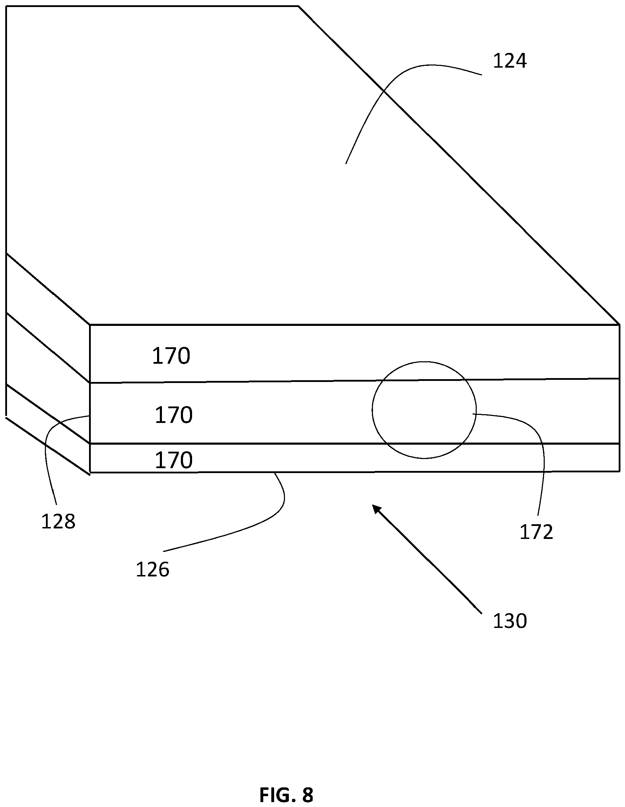

In one preferred embodiment of the system of the present invention, each VSO may contain sub-VSOs in a tiered manner. For example, DVSO generator 104 may automatically define a primary or top tier DVSO as the entirety of the road portion 120, based on the top-most and bottom-most surfaces thereof. Within that top tier VSO, second tier sub-VSOs may be automatically defined, corresponding to individual material layers 122 within road portion 120, such as VSOs 130 shown in Fig. 7. Some or all of these sub-VSOs may be further partitioned into third tier sub-sub VSOs, such as third tier sub-sub VSOs 170 of second tier sub-VSOs 130, shown in Fig. 8 and corresponding to sub-material layers within ones of the second tier sub-VSOs. Lower tier sub-VSOs, such as VSOs 130 and 170 may automatically inherit parameters of higher tier 'parent' VSOs in order to simplify the assignment of parameters between VSOs by parameter assigning functionality 140. Thus, for example, parameters of the top tier VSO representing the entirety of road portion 120 may be automatically assigned once to the top tier VSO and then automatically bequeathed to lower tier VSOs, such as VSOs 130 and 170, partitioned from within the top tier VSO.

The automatic partition of the road into multiple tiers of VSOs and the automatic inheritance by lower tier VSOs of parameters associated with upper tier VSOs may be modified by a user of system 100. For example, a user of system 100 may modify the automatic partition of VSOs to select additional or alternative VSOs and/or may adjust the parameters thereof.

Additionally, 3D finite BIM elements may be imported into system 100 and integrated with the DVSOs defined by DVSO generator 104. Such BIM finite elements may then be handled by system 100 as DVSOs and assigned the same parameters and functionalities as DVSOs. An example of an imported finite element in the form of a pipe 172 is shown in Fig. 8. As seen in Fig. 8, pipe 172 may be located within DVSO 130 and span several ones of sub-DVSOs 170. A volume of DVSOs 130 and relevant ones of sub-DVSOs 170 may be automatically adjusted by DVSO calculator 108 to take into account the presence of pipe 172. Furthermore, the importation of finite BIM elements from other BIM platforms into system 100 may be useful in assessing potential geometrical conflicts between the positions of such elements within the project to be built.

Returning to Fig. 1, in accordance with a preferred embodiment of the present invention, the project is then imaged, preferably by an Image Generator 180. Image generator 180 may be embodied as a photograph generator, employing one or more drones and photograph compositing software, and photographing the project at selected time intervals, which may be predetermined and may be periodic, such as weekly, throughout the duration of the project. Multiple photographs are produced and stored by the photograph generator 180.

Additionally or alternatively, image generator 180 may include one or more laser scanning machines, which laser scanning machines may be terrestrial, mobile and/or airborne. An example of a laser scanner suitable for use as image generator 180 is a Laser Scanner machine commercially available from Leica Geosystem of St. Gallen, Switzerland or Trimble Inc. of Sunnyvale, CA, USA.

Further additionally or alternatively, image generator 180 may include an RTK GPS or Total Station measurement system. RTK GPS equipment is commercially available from geodetic geospatial providers, such as Leica Geosystem of St. Gallen, Switzerland, Trimble Inc. of Sunnyvale, CA, USA, or Topcon Positioning of Tokyo, Japan. RTK GPS or Total Station measurements may be used as stand-alone measurement systems. Alternatively, RTK GPS or Total Station measurements may be used in combination with photographs and/or laser scanning, in order to enhance the precision of point clouds generated based thereon.

It is a particular feature of an embodiment of the present invention that information from the image generator 180 is employed by a Point Cloud Generator 182 for automatically generating a point cloud representing the project at each of the plurality of different times, the resulting point cloud including a multiplicity of points each having known Cartesian coordinates.

The Point Cloud Generator182 preferably generates a point cloud by one of several methods. In a first method, Point Cloud Generator 182 generates the point cloud based on laser images measured by laser scanning machines, which measure thousands of points and generate X, Y, Z coordinates by distance and angle measurements. In a second method, the Point Cloud Generator 182 generates a point cloud using conventional photo-scan generation algorithms, based on computer vision science that converts a set of images taken by a digital camera, in a way that preserves overlaps between images of the same photographed area, to point clouds. These algorithms are typically software implemented, such as Agisoft Metashape software, commercially available from Agisoft LLC of St. Peterburg, Russia, Pix4D mapper software, commercially available from Pix4D S.A. of Prilly, Switzerland, or DatuSurvey software, commercially available from Datumate, Yoqneam Ilit, Israel.

Real Time Kinematic (RTK) GPS or Total Station measurements may be used to enhance the precision of the points in the point cloud. Furthermore, point cloud generator 182 may additionally receive multi-sensor datasets, including infrared and spectral data relating to the imaged project. Data from these data sets may be integrated within the point cloud, by combining the sensed data with the points forming the point cloud.

In a third method, the Point Cloud Generator 182 generates a point cloud using RTK GPS or Total Station measurements. It is appreciated that Point Cloud Generator may generate a point cloud in accordance with a combination of these methods or any other suitable method or methods, as may be known in the art.

Irrespective of the particular type or types of data received by point cloud generator 182, point cloud generator 182 is preferably operative to calculate the precision and accuracy of each data set provided thereto, eliminate artefacts therein and perform data smoothing in order to generate the point cloud. Furthermore, point cloud generator 182 may characterize the data set in terms of the geodetic quality thereof based the resolution, precision and accuracy of the data set. The precision and accuracy of the data set on which the point cloud is based may be provided to a user of system 100.

The point cloud is preferably employed by a Surface Mapping Generator 184 for automatically generating a surface mapping representing the project at each of the plurality of different times that the project is imaged, based on the point clouds.

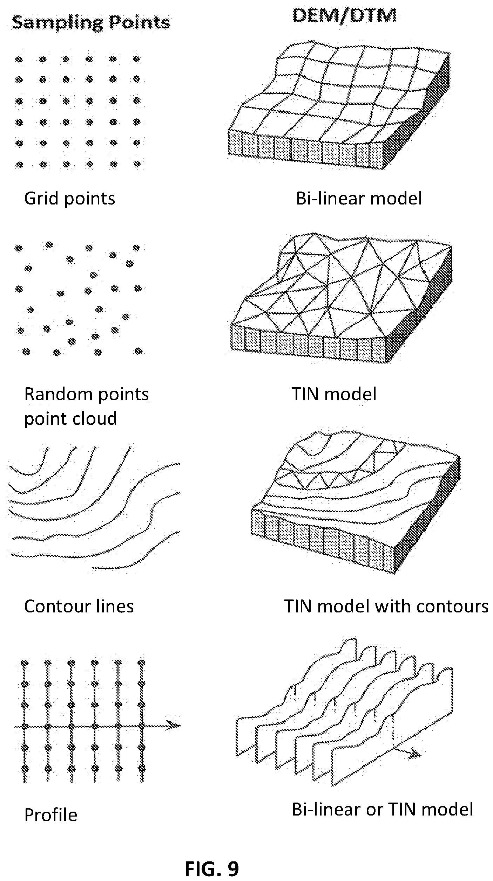

Surface Mapping Generator 184 preferably generates a surface mapping using one or more conventional algorithms, for example using triangulation methods or grid methods, based on one or more of grid points, random points point cloud, Contour Lines or Horizontal Profile, as seen in Fig. 9. It is understood that the surface mapping methods illustrated in Fig. 9 are by way of example only and that any suitable surface mapping methods, various types of which are known in the art, may be employed. More preferably, surface mapping generator184 generates a surface based on either contour lines for building the DVSO given by designers or by using one or more of the horizontal alignment, as seen in Fig. 2, the vertical profile, as seen in Fig. 3, the horizontal profile, as seen in Fig. 4, the 3D design view, as seen in Fig. 5, and the road layer structure, as seen in Fig. 6.

The surface mapping is preferably employed by an As-Built Volume-Surface-Objects (ABVSOs) Generator 186, which generates each ABVSO, preferably based on a pair of surface mappings at two points in time. It is a particular feature of an embodiment of the present invention that each of the ABVSOs corresponds to one of said plurality of DVSOs.

ABVSO generator 186 preferably generates an ABVSO utilizing two as-built surfaces, the first as-built surface being generated from images taken at an initial point in time and representing a first, lower surface of the ABVSO and the second as-built surface being generated from images taken at a later point in time and representing a second, upper surface of the ABVSO. The pair of as-built surfaces may, but do not necessarily, correspond to two immediately sequential points in time. The as-built surface is preferably based on a point cloud, generated as described above using cameras and/or laser scanners, and/or may be based on plural arbitrary measured points X, Y, Z or grid points X, Y, Z, which may be derived by known geodetic measurement instruments, such as a Real Time Kinematic (RTK) GPS, commercially available from geodetic geospatial providers, such as Leica Geosystem of St. Gallen, Switzerland, Trimble Inc. of Sunnyvale, CA, USA, or Topcon Positioning of Tokyo, Japan.

It is appreciated that As-Built surfaces are based on the same coordinate system as the coordinate system used in the design on which the DVSO is based, preferably, utilizing Ground Control Points (GCPs) measured in the field during the Point Cloud and the plural points generation.

ABVSO generator 186 preferably generates each ABVSO by linearly connecting boundaries of the two as-built surfaces, so as to define and enclose a volumetric geometrical unit, the volume of which may be calculated by an ABVSO geometric property calculator 188 and subsequently employed for project progress reporting and accounting, as is described in greater detail henceforth. It is understood that ABVSO Geometrical Property Calculator 188 is not limited to calculating the volume of the ABVSO, but may also calculate other geometrical properties of the ABVSO, including, for example, surface area, surface length, slope, and any other relevant properties.

ABVSO generator 186 is preferably operative to create a computerized volumetric virtual memory unit corresponding to and representing each ABVSO. The as-built volumetric geometrical unit and the volumetric virtual memory unit by which the as-built volumetric geometrical unit may be represented are referred to interchangeably herein as an As Built volume-surface-object (VSO). Parameters may, although are not necessarily assigned, to some or all of the ABVSOs. For example, actual costs incurred to date in constructing the ABVSO may be input to system 100 by a user thereof or a photograph of the as-built surface may be assigned to the ABVSO.

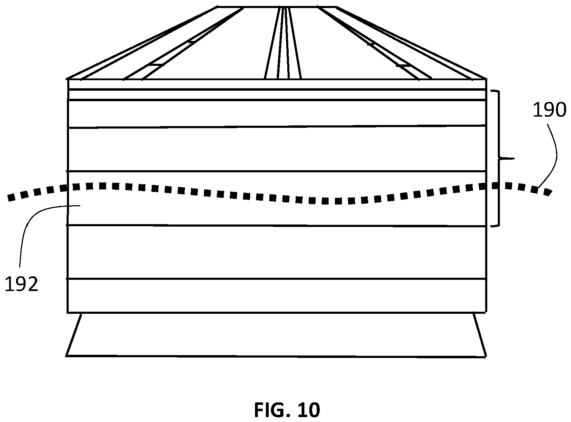

The system of the present invention preferably automatically classifies each ABVSO to a DVSO based on the 3D position of the ABVSO in the same coordinate system of the design, as seen in Fig. 10, wherein an upper surface 190 of an ABVSO is located within a material layer 192 of the road design and thus classified as matching the DVSO corresponding to that material layer 192. Once a particular ABVSO has been classified as matching a given DVSO, the system of the present invention may automatically assign to the particular ABVSO those parameters previously assigned to the given DVSO corresponding to the ABVSO. However, such parameters may be modified or added to by a user of system 100.

ABVSOs are typically defined progressively by adding As-Built surfaces during the monitoring progress life cycle each time a mapping process is done by a user in the field using one or more of the following methods: taking images by drone and generating point cloud by photo-scan algorithm, laser scanning using one or more Laser Scanner machines, and/or using RTK GPS geodetic measurements machines for plural points coordinates dataset, and/or any other suitable image generating mapping process. The most recent Surface As-Built added will be the top surface defined in the ABVSO in the system of the present invention.

It is a particular feature of an embodiment of the present invention that the system is operative to store each DVSO and the corresponding ABVSO for each time that the project is imaged or measured. By comparing the ABVSOs to each other and to the DVSO, Project Construction, Reporting and Accounting Functionality 1000 may automatically produce construction implementation instructions, progress reports and quantity reports based on each individual DVSO and corresponding ABVSO.

Comparing the ABVSOs to each other and to the corresponding DVSOs may involve a variety of types of comparisons performed between ABVSOs and DVSOs corresponding thereto and/or between the same ABVSOs at different points in time, based on which computerized analytics and reports useful to a user of the present invention may be automatically generated. Such analytics may be provided with respect to entire or portions of specific, individual ABVSOs and corresponding DVSOs, or with respect to multiple ABVSOs and corresponding DVSOs.

By way of example, a geometric comparison may be performed between an ABVSO and the DVSO corresponding thereto. Such a geometric comparison may involve computing differences, in three dimensions, between the ABVSO and the DVSO corresponding thereto, including differences in volume and area.

Further by way of example, a geometric comparison may be performed between ABVSOs at two different points in time, which ABVSOs correspond to the same DVSO. Such a geometric comparison may involve computing differences between one or more geometric parameters of the ABVSOs at two different points in time and/or one or more of the geometric parameters of the ABVSOs at two different points in time relative to one or more geometric parameters of the corresponding DVSO. Relevant geometric parameters to be computed may include, but are not limited to, volume, surface area, length and incline. Such a comparison may be useful for cost computation and future cost prediction.

Further by way of example, comparisons between ABVSOs corresponding to the same DVSO and between ABVSOs and the DVSOs corresponding thereto may be performed based on the time and schedule parameters thereof. This may involve computing the expected date at which an ABVSO will be completed, based on the past progress thereof, versus the design schedule of the DVSO corresponding to the ABVSO, in order to predict whether the ABVSO will meet the scheduled completion date. A computerized output may be provided to a user displaying whether or not the ABVSO is expected to meet the deadline thereof.

Further by way of example, comparisons between ABVSOs corresponding to the same DVSO and between ABVSOs and the DVSOs corresponding thereto may be performed based on cost and budget data associated therewith. For example, budgeted costs associated with a DVSO, for example by DVSO parameter assigning functionality 140 of Fig. 1, may be compared to actual costs incurred in constructing the ABVSO corresponding thereto or the remaining cost expected to be involved in construction of the ABVSO may be calculated.

By way of example, based on comparing individual DVSOs to the ABVSOs corresponding thereto, control instructions may be provided to construction machinery used in constructing the project; based on comparing individual DVSOs to the ABVSOs corresponding thereto, accounting and paying may be carried out for at least one of excavating and moving earth for constructing the infrastructure project; accounting and paying may be carried out for materials used in the infrastructure project; progress of the project may be monitored vis-à-vis a predetermined schedule; and progress of the project may be monitored vis-à-vis a pre-defined design.

Furthermore, functionality 1000 may include graphically representing the project at various times during the construction thereof, together with associated data, such as volume or area of the ABVSO, of interest to a user. The data may be presented to a user together with the accuracy thereof, for example as a ± error range, in order to allow the user to assess the accuracy of the data.

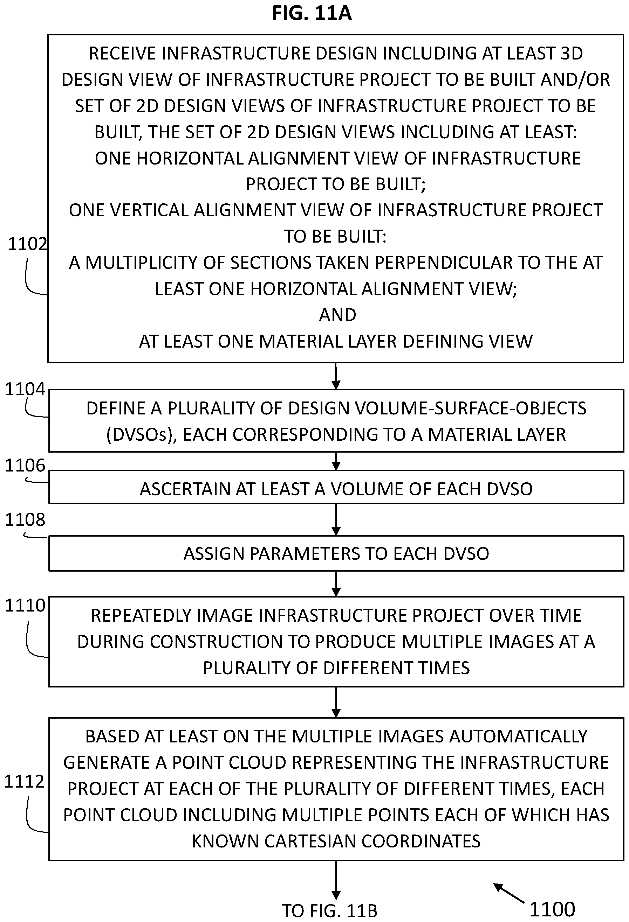

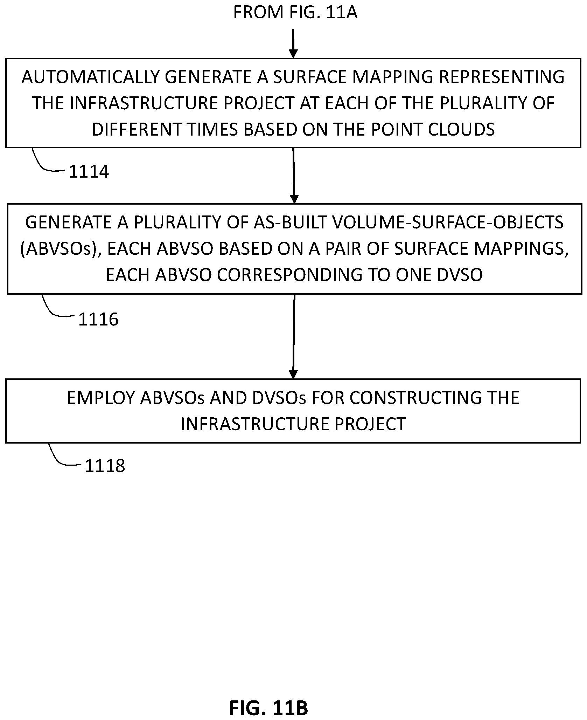

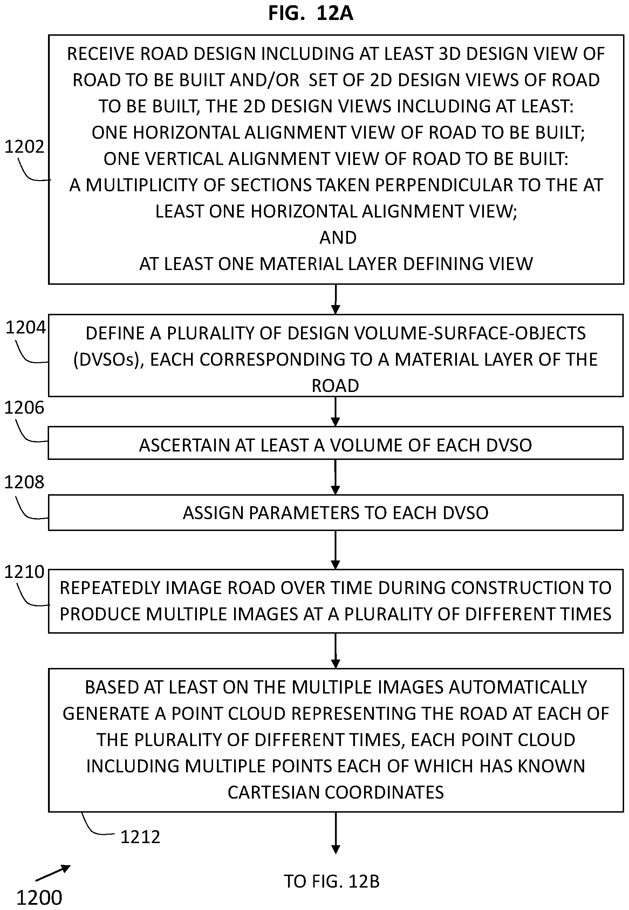

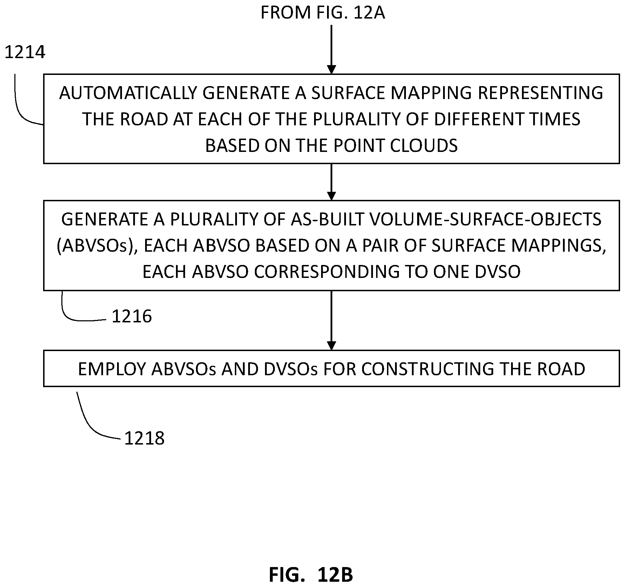

The method of the present invention, as may be performed by system 100, is shown generally in Figs. 11A and 11B and in the context of road building in Figs. 12A and 12B.

Turning first to Figs. 11A and 11B, a method 1100 in accordance with a preferred embodiment of the present invention may include, at a first step 1102, receiving an infrastructure project design including at least a 3D design view of an infrastructure project to be built and/or a set of 2D design views of the infrastructure project to be built. The set of 2D design views preferably includes at least one horizontal alignment view of the project to be built, one vertical alignment view of the project to be built and a multiplicity of sections taken perpendicular to the at least one horizontal alignment view. In addition to the 3D view and/or set of 2D views, at least one material layer defining view is also received at step 1102. It is understood that in the case that first step 1102 includes receiving a 3D design view, such a 3D design view may in some instances include material layer defining information, such that no additional material layer defining view is required.

As seen at a second step 1104, method 1100 further preferably includes defining a plurality of DVSOs, each corresponding to a material layer and calculating a volume of each of these DVSOs, as seen at a third step 1106. As seen at a fourth step 1108, method 1100 further includes assigning parameters to each DVSO. As seen at a fifth step 1110, method 1100 further includes imaging the infrastructure project over time, during the construction thereof, so as to produce multiple images at a plurality of different times.

As seen at a sixth step 1112, based at least on the multiple images, method 1100 preferably includes automatically generating a point cloud representing the infrastructure project at each of the plurality of different times, each point cloud including multiple points each of which has known Cartesian coordinates.

As seen at a seventh step 1114, method 1100 further preferably includes automatically generating surface mapping representing the infrastructure project at each of the plurality of different times based on the cloud points. As seen at an eighth step 1116, method 1100 further preferably includes generating a plurality of ABVSOs, ABVSO being based on a pair of surface mappings taken at two different points in time, each ABVSO corresponding to a DVSO. Further, as seen at a ninth step 1118, the ABVSOs and DVSOs are preferably employed for constructing the infrastructure project.

Turning now to Figs. 12A and 12B, a method 1200 in accordance with another preferred embodiment of the present invention may include, at a first step 1202, receiving a road design including at least a 3D design view of a road to be built and/or a set of 2D design views of the road to be built. The set of 2D design views preferably includes at least one horizontal alignment view of the road to be built, one vertical alignment view of the road to be built and a multiplicity of sections taken perpendicular to the at least one horizontal alignment view. In addition to the 3D view and/or set of 2D views, at least one material layer defining view is also received at step 1202. It is understood that in the case that first step 1202 includes receiving a 3D design view, such a 3D design view may in some instances include material layer defining information, such that no additional material layer defining view is required.

As seen at a second step 1204, method 1200 further preferably includes defining a plurality of DVSOs, each corresponding to a material layer and calculating a volume of each of these DVSOs, as seen at a third step 1206. As seen at a fourth step 1208, method 1200 further includes assigning parameters to each DVSO. As seen at a fifth step 1210, method 1200 further includes imaging the road over time, during the construction thereof, so as to produce multiple images at a plurality of different times.

As seen at a sixth step 1212, based at least on the multiple images, method 1200 preferably includes automatically generating a point cloud representing the road at each of the plurality of different times, each point cloud including multiple points each of which has known Cartesian coordinates.

As seen at a seventh step 1214, method 1200 further preferably includes automatically generating surface mapping representing the road at each of the plurality of different times based on the point clouds. As seen at an eighth step 1216, method 1200 further preferably includes generating a plurality of ABVSOs, ABVSO being based on a pair of surface mappings taken at two different points in time, each ABVSO corresponding to a DVSO. Further, as seen at a ninth step 1218, the ABVSOs and DVSOs are preferably employed for constructing the road.

Certain components of the system and method of the present invention for dynamic modelling of infrastructure projects over time, as described hereinabove with reference to Figs. 1 - 12B, may be executed by a processor, for example by a processor of local server or cloud based server. In accordance with embodiments of the present invention, a computer program application stored in a computer readable medium (e.g. register memory, processor cache, RAM, ROM, hard drive, flash memory, CD ROM, magnetic media, etc.) may include code or executable instructions that when executed may instruct or cause a controller or processor to perform one or more of the functionalities and methods discussed herein, such as a method for dynamically modelling infrastructure projects over time based on employing DVSOs and ABVSOs, in accordance with the present invention. The computer readable medium may be a non-transitory computer readable medium including all forms and types of computer-readable media.

It will be appreciated by persons skilled in the art that the present invention is not limited by what has been described hereinabove. Rather the present invention includes both combinations and sub-combinations of features described hereinabove as well as modifications thereof which are not in the prior art.

## Claims

1. A method (100) for dynamic modeling of infrastructure projects over time, the method comprising:
receiving (102) an infrastructure project design comprising:
at least one of a three-dimensional view of an infrastructure project to be built and a set of two-dimensional views of said infrastructure project; and
material layer defining information relating to said infrastructure project;
defining (104) a plurality of design volume-surface-objects (DVSOs), each corresponding to a material layer of said infrastructure project;
ascertaining at least a volume of each of said DVSOs; repeatedly imaging (180) said infrastructure project over time during construction thereof to produce multiple images acquired at a plurality of different times;
automatically generating (182) a point cloud representing said infrastructure project at each of said plurality of different times, based on said images, said point cloud including multiple points each having known Cartesian coordinates;
automatically generating (184) a surface mapping representing said infrastructure project at each of said plurality of different times, based on said point clouds;
automatically generating (186) a plurality of as-built volume-surface-objects (ABVSOs), each based on a pair of said surface mappings comprising a first as-built surface generated from images taken at an initial point in time and representing a first, lower surface of the ABVSO and a second as-built surface generated from images taken at a later point in time and representing a second, upper surface of the ABVSO each said ABVSO being generated by linearly connecting boundaries of said two as-built surfaces, so as to define and enclose a volumetric geometrical unit, each of said ABVSOs corresponding to one of said plurality of DVSOs; and
employing (1000) said ABVSOs and said DVSOs for constructing and managing said infrastructure project.

2. The method according to claim 1, wherein said set of two-dimensional views comprises:
at least one horizontal alignment view of said infrastructure project;
at least one vertical alignment view of said infrastructure project; and
a multiplicity of sectional views taken perpendicular to said at least one horizontal view.

3. The method according to claim 1 or claim 2, and wherein said employing said ABVSOs and said DVSOs for constructing and managing said infrastructure project comprises at least one of:
providing control instructions to construction machinery used in constructing said infrastructure project;
accounting and paying for at least one of excavating and moving earth for constructing said infrastructure project;
accounting and paying for materials used in said infrastructure project;
monitoring progress of said infrastructure project vis-à-vis a predetermined schedule; and
monitoring progress of said infrastructure project vis-à-vis a pre-defined design.

4. The method according to any one of the preceding claims, and also comprising graphically representing said infrastructure project at each of said plurality of different times.

5. The method according to any one of the preceding claims, wherein said imaging comprises at least one of photographing by a camera and laser scanning.

6. The method according to any one of the preceding claims, and also comprising employing RTK GPS positioning techniques to enhance a precision of said multiple points comprising said point cloud.

7. The method according to any one of the preceding claims, wherein said defining a plurality of DVSOs comprising automatically defining at least one DVSO and automatically defining within said a least one DVSO sub-DVSOs included in said at least one DVSO.

8. The method according to claim 7, and also comprising assigning at least one parameter to said at least one DVSO, said sub-DVSOs included in said at least one DVSO automatically inheriting said at least one parameter from said at least one DVSO.

9. The method according to claim 8, wherein said assigning at least one parameter comprises at least one of assignation of a sub-contractor contracted to construct said at least one DVSO, assignation of scheduled start date for construction of said at least one DVSO, assignation of a scheduled completion date for construction of said at least one DVSO, and assignation of an identification number of said at least one DVSO.

10. The method according to any one of the preceding claims and also comprising importing at least one modeled finite element to be located at a location within said infrastructure project, from an external Building Information Modelling (BIM) platform having modeled said finite element to said plurality of DVSOs, and incorporating said at least one finite element within ones of said plurality of DVSOs corresponding to said location.

11. A system for dynamic modeling of infrastructure projects over time, the system comprising:
a project design generator operative to generate an infrastructure project design comprising:
at least one of a three-dimensional view of an infrastructure project to be built and a set of two-dimensional views of said infrastructure project; and
material layer defining information relating to said infrastructure project;
a design volume-surface-objects (DVSOs) generator operative to define a plurality of DVSOs, each corresponding to a material layer of said infrastructure project;
a DVSO geometrical property calculator operative to ascertain at least one geometrical property of each of said DVSOs;
an image generator operative to repeatedly image said infrastructure project over time during construction thereof to produce multiple images acquired at a plurality of different times;
a point cloud generator operative to automatically generate a point cloud representing said infrastructure project at each of said plurality of different times, based on said images, said point cloud including multiple points each having known Cartesian coordinates;
a surface mapping generator operative to automatically generate a surface mapping representing said infrastructure project at each of said plurality of different times, based on said point clouds;
an As-Built Volume-Surface Object generator operative to automatically generate a plurality of as-built volume-surface-objects (ABVSOs), each based on a pair of said surface mappings, by utilizing a first as-built surface generated from images taken at an initial point in time and representing a first, lower surface of the ABVSO and a second as-built surface generated from images taken at a later point in time and representing a second, upper surface of the ABVSO, said As-Built Volume-Surface Object generator being operative to generate each said ABVSO by linearly connecting boundaries of said two as-built surfaces, so as to define and enclose a volumetric geometrical unit, each of said ABVSOs corresponding to one of said plurality of DVSOs; and
project construction and management functionality operative to employ said ABVSOs and said DVSOs for constructing and managing said infrastructure project.

12. The system according to claim 11, wherein said set of two-dimensional views comprises:
at least one horizontal alignment view of said infrastructure project;
at least one vertical alignment view of said infrastructure project; and
a multiplicity of sectional views taken perpendicular to said at least one horizontal view.

13. The system according to claim 11 or claim 12, and wherein said project construction and management functionality is operative to at least one of:
provide control instructions to construction machinery used in constructing said infrastructure project;
account and pay for at least one of excavating and moving earth for constructing said infrastructure project;
account and pay for materials used in said infrastructure project;
monitor progress of said infrastructure project vis-à-vis a predetermined schedule; and
monitor progress of said infrastructure project vis-à-vis a pre-defined design.

14. The system according to any one of claims 11 - 13, and wherein said project construction and management functionality also comprises project reporting functionality operative to graphically represent said infrastructure project at each of said plurality of different times.

15. The system according to any one of claims 11 - 14, wherein said DVSO generator is operative to automatically define at least one DVSO and to automatically define within said a least one DVSO sub-DVSOs included in said at least one DVSO.

## Patentansprüche

1. Verfahren (100) zum dynamischen Modellieren von Infrastrukturprojekten im Zeitverlauf, das Verfahren umfassend:
Empfangen (102) eines Entwurfs eines Infrastrukturprojekts, der mindestens eine dreidimensionale Ansicht eines zu bauenden Infrastrukturprojekts und/oder einen Satz zweidimensionaler Ansichten des Infrastrukturprojekts umfasst; und
eine Materialschicht, die Informationen zu dem Infrastrukturprojekt definiert;
Definieren (104) einer Vielzahl von Entwurfs-Volumen-Oberflächen-Objekten (DVSOs), die jeweils einer Materialschicht des Infrastrukturprojekts entsprechen;
Ermitteln mindestens eines Volumens jedes der DVSOs;
wiederholtes Abbilden (180) des Infrastrukturprojekts im Laufe der Zeit während dessen Errichtung, um mehrere Bilder zu erstellen, die zu einer Vielzahl unterschiedlicher Zeiten aufgenommen wurden;
automatisches Generieren (182) einer Punktwolke, die das Infrastrukturprojekt zu jedem der Vielzahl von verschiedenen Zeitpunkten darstellt, auf der Grundlage der Bilder, wobei die Punktwolke mehrere Punkte einschließt, die jeweils bekannte kartesische Koordinaten aufweisen;
automatisches Generieren (184) einer Oberflächenkartierung, die das Infrastrukturprojekt zu jedem der Vielzahl von verschiedenen Zeitpunkten darstellt, auf der Grundlage der Punktwolken;
automatisches Generieren (186) einer Vielzahl von As-Built-Volumen-Oberflächen-Objekten (ABVSOs), jeweils basierend auf einem Paar der Oberflächenkartierungen, umfassend eine erste As-Built-Oberfläche, die aus Bildern generiert wird, die zu einem Anfangszeitpunkt angefertigt werden, und eine erste, untere Oberfläche des ABVSO darstellt, und eine zweite As-Built-Oberfläche, die aus Bildern generiert wird, die zu einem späteren Zeitpunkt angefertigt werden, und eine zweite, obere Oberfläche der ABVSOs darstellt, wobei jedes ABVSO durch lineare Verbindung der Grenzen der beiden As-Built-Oberflächen generiert wird, um eine volumetrische geometrische Einheit zu definieren und abzugrenzen, wobei jedes der ABVSOs einer der Vielzahl von DVSOs entspricht; und Verwenden (1000) der ABVSOs und der DVSOs zum Errichten und Verwalten des Infrastrukturprojekts.

2. Verfahren nach Anspruch 1, wobei der Satz zweidimensionaler Ansichten umfasst:
mindestens eine horizontale Ausrichtungsansicht des Infrastrukturprojekts;
mindestens eine vertikale Ausrichtungsansicht des Infrastrukturprojekts; und
eine Vielfalt von Schnittansichten, die senkrecht zu der mindestens einen horizontalen Ansicht angefertigt werden.

3. Verfahren nach Anspruch 1 oder 2, wobei das Verwenden der ABVSOs und der DVSOs zum Errichten und Verwalten des Infrastrukturprojekts mindestens eines der folgenden umfasst:
Bereitstellen von Steueranweisungen für Baumaschinen, die beim Errichten des Infrastrukturprojekts verwendet werden;
Abrechnen und Bezahlen von mindestens einem der folgenden Vorgänge: Ausheben und Bewegen von Erde für das Errichten des Infrastrukturprojekts;
Abrechnen und Bezahlen von Materialien, die für das Infrastrukturprojekt verwendet werden;
Überwachen des Fortschritts des Infrastrukturprojekts im Vergleich zu einem vorgegebenen Zeitplan; und
Überwachen des Fortschritts des Infrastrukturprojekts im Vergleich zu einem vorab definierten Entwurf.

4. Verfahren nach einem der vorhergehenden Ansprüche und auch umfassend das grafische Darstellen des Infrastrukturprojekts zu jedem der Vielzahl von verschiedenen Zeitpunkten.

5. Verfahren nach einem der vorhergehenden Ansprüche, wobei das Abbilden das Fotografieren mit einer Kamera und/oder das Laserscannen umfasst.

6. Verfahren nach einem der vorhergehenden Ansprüche und auch umfassend das Verwenden von RTK-GPS-Positionierungstechniken, um die Präzision der mehreren Punkte, die die Punktwolke umfassen, zu verbessern.

7. Verfahren nach einem der vorhergehenden Ansprüche, wobei das Definieren einer Vielzahl von DVSOs das automatische Definieren von mindestens einem DVSO und das automatische Definieren von Unter-DVSOs innerhalb des mindestens einen DVSO umfasst, die in dem mindestens einen DVSO eingeschlossen sind.

8. Verfahren nach Anspruch 7 und auch umfassend das Zuordnen mindestens eines Parameters zu dem mindestens einen DVSO, wobei die in dem mindestens einen DVSO eingeschlossenen Unter-DVSOs den mindestens einen Parameter automatisch von dem mindestens einen DVSO übernehmen.

9. Verfahren nach Anspruch 8, wobei das Zuweisen mindestens eines Parameters mindestens eines der folgenden umfasst: Zuweisung eines Subunternehmers, der mit dem Errichten des mindestens einen DVSO beauftragt ist, Zuweisung eines geplanten Startdatums für die Errichtung des mindestens einen DVSO, Zuweisung eines geplanten Abschlussdatums für die Errichtung des mindestens einen DVSO und Zuweisung einer Identifikationsnummer des mindestens einen DVSO.

10. Verfahren nach einem der vorhergehenden Ansprüche und auch umfassend das Importieren mindestens eines modellierten finiten Elements, das an einer Position innerhalb des Infrastrukturprojekts positioniert werden soll, aus einer externen Building-Information-Modeling (BIM)-Plattform, die das finite Element modelliert hat, zu der Vielzahl von DVSOs, und Einfügen des mindestens einen finiten Elements in eines der Vielzahl von DVSOs, das der Position entspricht.

11. System zum dynamischen Modellieren von Infrastrukturprojekten im Zeitverlauf, das System umfassend:
einen Projektentwurfsgenerator, der einen Infrastrukturprojektentwurf generiert, umfassend:
mindestens eine dreidimensionale Ansicht eines zu bauenden Infrastrukturprojekts und einen Satz zweidimensionaler Ansichten des Infrastrukturprojekts; und
eine Materialschicht, die Informationen zu dem Infrastrukturprojekt definiert;
einen Entwurfs-Volumen-Oberflächen-Objektgenerator (DVSO), der dazu eingesetzt werden kann, eine Vielzahl von DVSOs zu definieren, die jeweils einer Materialschicht des Infrastrukturprojekts entsprechen;
einen DVSO-Geometrieeigenschaftsrechner, der dazu eingesetzt werden kann, mindestens eine Geometrieeigenschaft jedes der DVSOs zu ermitteln;
einen Bildgenerator, der dazu eingesetzt werden kann, das Infrastrukturprojekt während seiner Bauzeit wiederholt abzubilden, um mehrere Bilder zu erstellen, die zu einer Vielzahl von verschiedenen Zeitpunkten aufgenommen werden;
einen Punktwolkengenerator, der dazu eingesetzt werden kann, automatisch eine Punktwolke zu erzeugen, die das Infrastrukturprojekt zu jedem der Vielzahl von verschiedenen Zeitpunkten darstellt, basierend auf den Bildern, wobei die Punktwolke mehrere Punkte einschließt, die jeweils bekannte kartesische Koordinaten aufweisen;
einen Oberflächenkartierungsgenerator, der dazu eingesetzt werden kann, dass er automatisch eine Oberflächenkartierung generiert, die das Infrastrukturprojekt zu jedem der Vielzahl von verschiedenen Zeitpunkten darstellt, basierend auf den Punktwolken;
einen As-Built-Volumen-Oberflächen-Objekt-Generator, der dazu eingesetzt werden kann, dass er automatisch eine Vielzahl von As-Built-Volumen-Oberflächen-Objekten (ABVSOs) generiert, die jeweils auf einem Paar der Oberflächenkartierungen basieren, indem er eine erste As-Built-Oberfläche verwendet, die aus Bildern generiert wird, die zu einem Anfangszeitpunkt angefertigt wurden und eine erste, untere Oberfläche des ABVSO darstellen, und eine zweite As-Built-Oberfläche verwendet, die aus Bildern generiert wird, die zu einem späteren Zeitpunkt angefertigt wurden und eine zweite, obere Oberfläche der ABVSO darstellt, wobei der As-Built-Volumen-Oberflächen-Objektgenerator dazu eingesetzt werden kann, dass er jedes ABVSO durch lineares Verbinden der Grenzen der beiden As-Built-Oberflächen generiert, um eine volumetrische geometrische Einheit zu definieren und abzugrenzen, wobei jedes ABVSO eines der Vielzahl von DVSO entspricht; und
eine Projekterrichtungs- und -verwaltungsfunktionalität, die so eingesetzt werden kann, dass sie die ABVSOs und die DVSOs für das Errichten und Verwalten des Infrastrukturprojekts verwendet.

12. System nach Anspruch 11, wobei der Satz zweidimensionaler Ansichten umfasst:
mindestens eine horizontale Ausrichtungsansicht des Infrastrukturprojekts;
mindestens eine vertikale Ausrichtungsansicht des Infrastrukturprojekts; und
eine Vielzahl von Schnittansichten, die senkrecht zu der mindestens einen horizontalen Ansicht angefertigt werden.

13. System nach Anspruch 11 oder 12, wobei die Projekterrichtungs- und - verwaltungsfunktionalität mindestens dazu eingesetzt werden kann, eine der folgenden Funktionen auszuführen:
Bereitstellen von Steueranweisungen für Baumaschinen, die beim Errichten des Infrastrukturprojekts verwendet werden;
Abrechnen und Bezahlen von mindestens einem der folgenden Vorgänge: Ausheben und Bewegen von Erde für das Errichten des Infrastrukturprojekts;
Abrechnen und Bezahlen von Materialien, die für das Infrastrukturprojekt verwendet werden;
Überwachen des Fortschritts des Infrastrukturprojekts im Vergleich zu einem vorgegebenen Zeitplan; und
Überwachen des Fortschritts des Infrastrukturprojekts im Vergleich zu einem vorab definierten Entwurf.

14. System nach einem der Ansprüche 11 bis 13, wobei die Projekterrichtungs- und - verwaltungsfunktionalität auch eine Funktionalität für die Berichterstattung über das Projekt umfasst, die das Infrastrukturprojekt zu jedem der Vielzahl von verschiedenen Zeitpunkten grafisch darstellt.

15. System nach einem der Ansprüche 11-14, wobei der DVSO-Generator dazu eingesetzt werden kann, dass er automatisch mindestens ein DVSO definiert und innerhalb dieses mindestens einen DVSO automatisch Unter-DVSOs definiert, die in diesem mindestens einen DVSO eingeschlossen sind.

## Revendications

1. Procédé (100) pour la modélisation dynamique de projets d'infrastructure dans le temps, le procédé comprenant les étapes consistant à :
recevoir (102) une conception de projet d'infrastructure comprenant
au moins un(e) parmi une vue tridimensionnelle d'un projet d'infrastructure à construire et un ensemble de vues bidimensionnelles dudit projet d'infrastructure ; et
des informations définissant des couches de matériau, relatives audit projet d'infrastructure ;
définir (104) une pluralité d'objets volume-surface de conception (DVSO), chacun correspondant à une couche de matériau dudit projet d'infrastructure ;
déterminer au moins un volume de chacun desdits DVSO ;
capturer des images (180) de façon répétée du projet d'infrastructure dans le temps au cours de sa construction afin de produire des images multiples acquises à une pluralité d'instants différents ;
générer automatiquement (182) un nuage de points représentant ledit projet d'infrastructure à chacun de ladite pluralité d'instants différents, sur la base desdites images, ledit nuage de points incluant de multiples points ayant chacun des coordonnées cartésiennes connues ;
générer automatiquement (184) un mappage de surface représentant ledit projet d'infrastructure à chacun de ladite pluralité d'instants différents, sur la base desdits nuages de points ;
générer automatiquement (186) une pluralité d'objets volume-surface tels que construits (ABVSO), chacun basé sur une paire desdits mappages de surface comprenant une première surface telle que construite, générée à partir d'images prises à un instant initial et représentant une première surface inférieure de l'ABVSO et une seconde surface telle que construite, générée à partir d'images prises à un instant ultérieur et représentant une seconde surface supérieure de l'ABVSO, chaque dit ABVSO étant généré en reliant linéairement les limites desdites deux surfaces telles que construites, de manière à définir et délimiter une unité géométrique volumétrique, chacun desdits ABVSO correspondant à l'un de ladite pluralité de DVSO ; et
utiliser (1000) lesdits ABVSO et lesdits DVSO pour construire et gérer ledit projet d'infrastructure.

2. Procédé selon la revendication 1, dans lequel ledit ensemble de vues bidimensionnelles comprend :
au moins une vue d'alignement horizontal dudit projet d'infrastructure ;
au moins une vue d'alignement vertical dudit projet d'infrastructure ; et
une multiplicité de vues en coupe prises perpendiculairement à ladite au moins une vue horizontale.

3. Procédé selon la revendication 1 ou la revendication 2, dans lequel ledit fait d'utiliser lesdits ABVSO et lesdits DVSO pour construire et gérer ledit projet d'infrastructure comprend au moins une opération parmi :
fournir des instructions de commande à la machinerie de construction utilisée pour construire ledit projet d'infrastructure ;
comptabiliser et payer au moins l'un des travaux d'excavation et de terrassement pour la construction dudit projet d'infrastructure ;
comptabiliser et payer les matériaux utilisés dans ledit projet d'infrastructure ;
surveiller l'avancement dudit projet d'infrastructure par rapport à un calendrier préétabli ; et
surveiller l'avancement dudit projet d'infrastructure par rapport à une conception prédéfinie.

4. Procédé selon l'une quelconque des revendications précédentes, et comprenant également représenter graphiquement ledit projet d'infrastructure à chacun de ladite pluralité d'instants différents.

5. Procédé selon l'une quelconque des revendications précédentes, dans lequel ledit fait de capturer des images comprend au moins une opération parmi : photographie par une caméra et balayage laser.

6. Procédé selon l'une quelconque des revendications précédentes, et comprenant également l'utilisation de techniques de localisation GPS RTK pour améliorer une précision desdits points multiples composant ledit nuage de points.

7. Procédé selon l'une quelconque des revendications précédentes, dans lequel ledit fait de définir une pluralité de DVSO comprend définir automatiquement au moins un DVSO et définir automatiquement au sein dudit au moins un DVSO des sous-DVSO inclus dans ledit au moins un DVSO.

8. Procédé selon la revendication 7, et comprenant également attribuer au moins un paramètre audit au moins un DVSO, lesdits sous-DVSO inclus dans ledit au moins un DVSO héritant automatiquement ledit au moins un paramètre dudit au moins un DVSO.

9. Procédé selon la revendication 8, dans lequel ledit fait d'attribuer au moins un paramètre comprend au moins une parmi l'attribution d'un sous-traitant engagé pour construire ledit au moins un DVSO, l'attribution d'une date de début prévue pour la construction dudit au moins un DVSO, l'attribution d'une date d'achèvement prévue pour la construction dudit au moins un DVSO, et l'attribution d'un numéro d'identification dudit au moins un DVSO.

10. Procédé selon l'une quelconque des revendications précédentes, et comprenant également importer au moins un élément fini modélisé devant être situé à un emplacement au sein dudit projet d'infrastructure, à partir d'une plateforme externe de modélisation des données du bâtiment (BIM), ayant modélisé ledit élément fini pour ladite pluralité de DVSO, et incorporer ledit dudit au moins un élément fini au sein de ladite pluralité de DVSO correspondant audit emplacement.

11. Système pour la modélisation dynamique de projets d'infrastructure dans le temps, comprenant
un générateur de conception de projet, opérationnel pour générer une conception de projet d'infrastructure comprenant :
au moins un(e) parmi une vue tridimensionnelle d'un projet d'infrastructure à construire et un ensemble de vues bidimensionnelles dudit projet d'infrastructure ; et
des informations définissant des couches de matériau, relatives audit projet d'infrastructure ;
un générateur d'objets volume-surface de conception (DVSO) opérationnel pour définir une pluralité de DVSO, chacun correspondant à une couche de matériau dudit projet d'infrastructure ;
un calculateur de propriétés géométriques de DVSO, opérationnel pour déterminer au moins une propriété géométrique de chacun desdits DVSO ;
un générateur d'images opérationnel pour capturer de façon répétée des images dudit projet d'infrastructure dans le temps au cours de sa construction afin de produire des images multiples acquises à une pluralité d'instants différents ;
un générateur de nuages de points opérationnel pour générer automatiquement un nuage de points représentant ledit projet d'infrastructure à chacun de ladite pluralité d'instants différents, sur la base desdites images, ledit nuage de points incluant de multiples points ayant chacun des coordonnées cartésiennes connues ;
un générateur de mappage de surface, opérationnel pour générer automatiquement un mappage de surface représentant ledit projet d'infrastructure à chacun de ladite pluralité d'instants différents, sur la base desdits nuages de points ;
un générateur d'objets volume-surface tels que construits, opérationnel pour générer automatiquement une pluralité d'objets volume-surface tels que construits (ABVSO), chacun basé sur une paire desdits mappages de surface, en utilisant une première surface telle que construite, générée à partir d'images prises à un instant initial et représentant une première surface inférieure de l'ABVSO et une seconde surface telle que construite, générée à partir d'images prises à un instant ultérieur et représentant une seconde surface supérieure de l'ABVSO, ledit générateur d'objets volume-surface tels que construits étant opérationnel pour générer chaque dit ABVSO en reliant linéairement les limites desdites surfaces telles que construites, de manière à définir et délimiter une unité géométrique volumétrique, chacun desdits ABVSO correspondant à l'un de ladite pluralité de DVSO ; et
une fonctionnalité de construction et gestion de projet, opérationnelle pour utiliser lesdits ABVSO et lesdits DVSO pour construire et gérer ledit projet d'infrastructure.

12. Système selon la revendication 11, dans lequel ledit ensemble de vues bidimensionnelles comprend :
au moins une vue d'alignement horizontal dudit projet d'infrastructure ;
au moins une vue d'alignement vertical dudit projet d'infrastructure ; et
une multiplicité de vues en coupe prises perpendiculairement à ladite au moins une vue horizontale.

13. Système selon la revendication 11 ou la revendication 12, et dans lequel ladite fonctionnalité de construction et gestion de projet est opérationnelle pour au moins une opération parmi :
fournir des instructions de commande à la machinerie de construction utilisée pour construire ledit projet d'infrastructure ;
comptabiliser et payer au moins l'un des travaux d'excavation et de terrassement pour la construction dudit projet d'infrastructure ;
comptabiliser et payer les matériaux utilisés dans ledit projet d'infrastructure ;
surveiller l'avancement dudit projet d'infrastructure par rapport à un calendrier préétabli ; et
surveiller l'avancement dudit projet d'infrastructure par rapport à une conception prédéfinie.

14. Système selon l'une quelconque des revendications 11 - 13, et dans lequel ladite fonctionnalité de construction et gestion de projet comprend également une fonctionnalité de rapport de projet opérationnelle pour représenter graphiquement ledit projet d'infrastructure à chacun de ladite pluralité d'instants différents.

15. Système selon l'une quelconque des revendications 11 - 14 dans lequel ledit générateur de DVSO est opérationnel pour définir automatiquement au moins un DVSO et pour définir automatiquement au sein dudit au moins un DVSO des sous-DVSO inclus dans ledit au moins un DVSO.
